# FASCICULE DE BREVET EUROPEEN

(11) **EP 0 999 642 B1**
(45) Date de publication et mention de la délivrance du brevet: **03.09.2003**
(21) Numéro de dépôt: 99402745.6
(22) Date de dépôt: 04.11.1999
(51) Int. Cl.: H03K 3/037, H03K 3/3562

(54) **Bascule maître-esclave de type D**
Typ D Master-Slave Kippschaltung
D-type master-slave flip-flop

(30) Priorité: 06.11.1998 FR 9814018
(43) Date de publication de la demande: 10.05.2000
(73) Titulaire: CSEM Centre Suisse d'Electronique et de Microtechnique S.A. Recherche et Développement, 2007 Neuchâtel (CH)
(72) Inventeur: Piguet, Christian, 2000 Neuchatel (CH); Masgonty, Jean-Marc, 2074 Marin (CH); Arm, Claude, 2016 Cortaillod (CH)
(74) Mandataire: Caron, Gérard

(56) Documents cités:
- US-A- 3 622 803
- US-A- 4 506 165
- US-A- 4 797 575

## Description

La présente invention est relative à une bascule maître-esclave de type D, avantageusement réalisée en technologie CMOS.

Une telle bascule maître-esclave est décrite dans un ouvrage de D. Mange, intitulé "Analyse et synthèse des systèmes logiques", Vol. V du "Traité d'électricité" Ecole Polytechnique Fédérale de Lausanne, Suisse, édité par les Editions Georgi, 1978, Page 260.

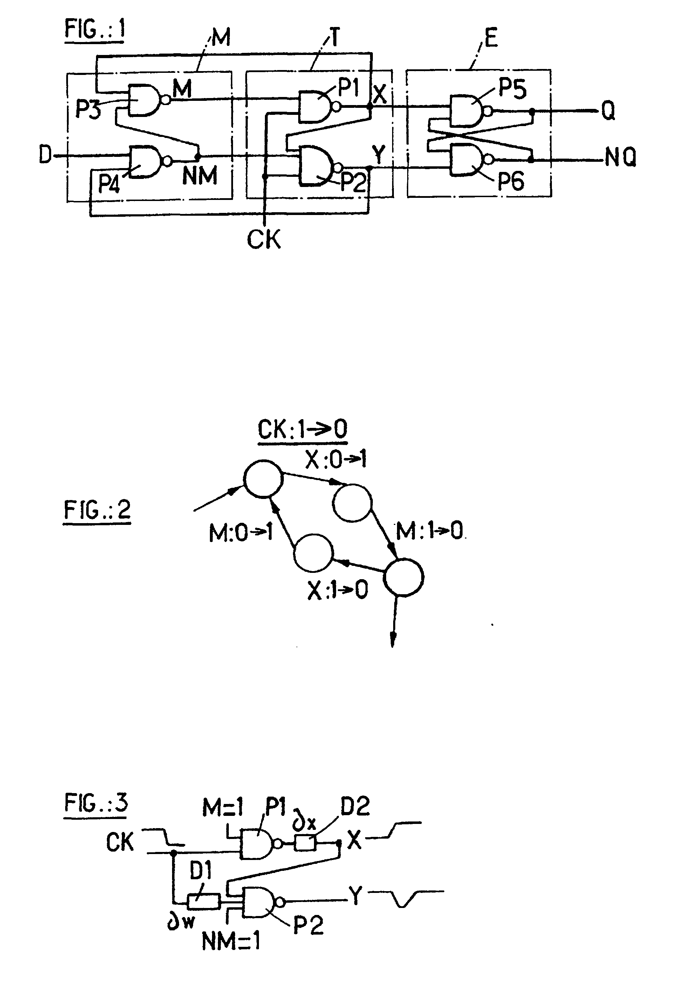

Comme représenté sur la figure 1 des dessins annexés, cette bascule maître-esclave connue comporte une unité maître M recevant une variable d'entrée D et produisant deux premières variables intermédiaires M et NM, toutes deux fonction de cette variable d'entrée. La bascule maître-esclave comprend également une unité esclave E destinée à former, à partir desdites premières variables intermédiaires M et NM, au moins une variable de sortie de la bascule Q et/ou NQ. Une unité de transfert T est connectée entre l'unité maître M et l'unité esclave E et comporte, respectivement pour chacune desdites variables de sortie Q et NQ, au moins une porte logique P1 et P2 destinée à combiner avec un signal d'horloge CK, les premières variables intermédiaires N et NM qui lui sont appliquées, en produisant deux secondes variables intermédiaires X et Y qui sont appliquées à l'unité esclave E.

Dans la variante de réalisation connue représentée, l'unité maître M comprend deux portes NON-ET P3 et P4, l'unité esclave E comportant deux portes NON-ET P5 et P6.

Les avantages essentiels de ce genre de bascules connues résident dans le fait que, d'une part elles ne présentent pas de course critique (en anglais "race") et d'autre part elles n'ont pas besoin d'un inverseur d'horloge. En outre, le signal d'horloge n'est appliqué qu'aux portes P1 et P2 de l'unité de transfert T. On se référera au document EP 0 734 122 pour une explication détaillée du concept "course critique" (qui est par ailleurs familier aux spécialistes).

Cependant, ces bascules présentent un inconvénient qui est dû à leur sensibilité à la pente du flanc montant ou descendant des impulsions du signal d'horloge CK.

Les figures 2 et 3 des dessins annexés illustrent les conséquences de cette sensibilité de la bascule à la pente du signal d'horloge. D'après le graphe de fonctionnement de la figure 2, on voit que, si le signal d'horloge CK change d'état, par exemple passe de "1" à "0", la variable X passe de "0" à "1" et la variable M passe de "1" à "O". Si pendant ce même processus, on considère la variable Y, on constate que la montée de la variable X crée une incertitude ou aléa (en anglais "glitch"), quant à la variable Y, si le signal d'horloge est relativement lent à parvenir à son niveau bas.

La figure 3 illustre ce phénomène par une modélisation de l'unité de transfert T dont la porte P2 reçoit le signal d'horloge CK par l'intermédiaire d'un délai D1 de durée ∂w et dont la porte P1 fournit la variable X par l'intermédiaire d'un délai D2 de durée ∂x. Il y a un aléa ou "glitch" sur la variable Y si ∂w > ∂x ce dont il peut résulter un basculement erroné de l'unité esclave E par un aléa 1 → 0 → 1 sur la variable Y.

L'invention a pour but de fournir une bascule maître-esclave de type D dans laquelle l'influence de la pente des flancs de l'impulsion du signal d'horloge est fortement réduite, voire complètement annulée.

L'invention a donc pour objet une bascule maître-esclave de type D réalisée en technologie CMOS, comportant:
- une unité maître recevant une variable d'entrée et produisant deux premières variables intermédiaires fonction de cette variable d'entrée,
- une unité de transfert, connectée à ladite unité maître et comportant au moins deux portes logiques, et une connexion d'horloge à laquelle est appliquée un signal d'horloge et qui est connectée à l'une des entrées de chacune de ces portes, celles-ci étant destinées à fournir respectivement deux secondes variables intermédiaires fonction de ladite variable d'entrée et dudit signal d'horloge et étant rebouclées sur ladite unité maître,
- une unité esclave connectée à ladite unité de transfert pour former, à partir desdites secondes variables intermédiaires, au moins une variable de sortie de la bascule,
- caractérisée en ce que
- une autre entrée d'une première desdites portes de ladite unité de transfert est connectée à ladite unité maître pour recevoir directement la valeur vraie de l'une desdites variables fournies par cette unité maître,
- une autre entrée de la seconde desdites portes de ladite unité de transfert est connectée à ladite unité maître pour recevoir de celle-ci le complément de la même variable parmi lesdites premières variables intermédiaires, et
- lesdites secondes variables intermédiaires sont indépendantes l'une de l'autre.

Une bascule de type D ayant ces caractéristiques, présente un très faible risque d'engendrer des situations instables correspondant à des aléas. Elle peut être réalisée moyennant un faible nombre de transistors, tout en assurant un temps de commutation favorable, sa réalisation pouvant comporter une topographie en branches dans laquelle chaque branche ne comporte qu'un seul transistor de type P et au plus deux transistors de type N en série.

Selon d'autres caractéristiques avantageuses de l'invention:
- ladite unité maître comprend un inverseur pour fournir le complément de ladite même première variable intermédiaire;
- lesdites unités maître, de transfert et esclave comprennent chacune deux portes NON-ET ou deux portes NON-OU;.
- une première porte de ladite unité maître est reliée pour recevoir sur une première de ses entrées ladite variable d'entrée et sur une deuxième de ses entrées l'une des variables intermédiaires rebouclées, une seconde porte de ladite unité maître est reliée pour recevoir sur une première de ses entrées la sortie de ladite première porte et sur une seconde de ses entrées l'autre desdites secondes variables rebouclées, et la sortie de ladite seconde porte est connectée à une entrée desdites première et seconde portes de ladite unité de transfert respectivement directement et par l'intermédiaire dudit inverseur;
- ladite unité maître comprend une porte ET recevant sur ses entrées respectivement ladite variable d'entrée et l'une des secondes variables intermédiaires rebouclées, et une porte NON-OU connectée par l'une de ses entrées à la sortie de ladite porte ET et recevant sur une autre de ses entrées l'autre seconde variable rebouclée, la sortie de ladite porte NON-OU étant reliée à ladite unité de transfert et audit inverseur.
- ladite unité esclave comporte deux portes logiques ayant chacune une première entrée connectée respectivement pour recevoir l'une desdites secondes variables intermédiaires, et une seconde entrée raccordée à la sortie de l'autre porte logique de cette unité esclave, les sorties desdites portes logiques délivrant chacune l'une desdites variables de sortie;
- ladite unité esclave comprend une porte ET dont l'une des entrées est connectée pour recevoir l'une desdites secondes variables intermédiaires, et dont la sortie est reliée à une première entrée d'une porte NON-OU dont l'autre entrée est connectée pour recevoir, sous forme inversée, l'autre desdites secondes variables intermédiaires, l'autre entrée de ladite porte ET est reliée à la sortie d'un inverseur fournissant une première desdites variables de sortie, et la sortie de ladite porte NON-OU est reliée à cet inverseur et fournit l'autre desdites variables de sortie;
- ladite unité de transfert est pourvue d'une entrée de commande sur une entrée d'au moins l'une de ses portes pour conférer à ladite bascule une fonction de set ou de reset.

L'invention a également pour objet une application de la bascule maître-esclave de type D telle que définie ci-dessus comme diviseur par deux, caractérisée en ce que l'une desdites variables de sortie est rebouclée pour constituer ladite variable d'entrée et en ce que lesdites secondes variables de sortie constituent des sorties en opposition de phase avec une fréquence qui est moitié de la fréquence dudit signal d'horloge.

D'autres caractéristiques et avantages de l'invention apparaîtront au cours de la description qui va suivre donnée uniquement à titre d'exemple et faite en se référant aux dessins annexés sur lesquels:
- la figure 1 est un schéma d'une bascule maître-esclave de type D de la technique antérieure;
- la figure 2 est un graphe illustrant le fonctionnement d'une partie de la bascule de la figure 1;
- la figure 3 est un schéma d'une simulation de certains délais intervenant dans le fonctionnement d'une bascule maître-esclave conçue selon le schéma de la figure 1;
- la figure 4 est un schéma d'une bascule maître-esclave de type D conforme à un premier mode de réalisation de l'invention;
- la figure 5 est un schéma d'une topographie en branches à l'aide de laquelle la bascule maître-esclave de la figure 4 est de préférence réalisée;
- la figure 6 représente un graphe illustrant le fonctionnement d'une partie de la bascule maître-esclave représentée sur les figures 4 et 5, lors de la transition de l'une des variables intermédiaires issues de son unité de transfert;
- la figure 7 est un diagramme des temps illustrant, d'une autre façon mais pour le même cas, le fonctionnement de cette bascule maître-esclave ;
- la figure 8 est un schéma d'une simulation de certains délais intervenant dans le fonctionnement de la bascule de la figure 4;
- les figures 9, 10 et 11 montrent, en ce qui concerne la transition de l'autre variable intermédiaire issue de l'unité de transfert de la bascule maître-esclave, des diagrammes analogues respectivement à ceux des figures 6, 7 et 8;
- les figures 12, 13 et 14 montrent trois autres modes de réalisation d'une bascule maître-esclave de type D selon l'invention;
- les figures 15 et 16 montrent deux schémas possibles d'une bascule maître-esclave selon les figures 4 et 5 dotée d'une fonction de rétablissement ou reset;
- la figure 17 est un schéma d'une bascule maître-esclave de type D selon l'invention, réalisée avec des portes à logique inverse par rapport à la logique des portes utilisées dans les précédentes figures;
- la figure 18 montrent une application de la bascule maître-esclave de type D suivant l'invention comme diviseur par deux destiné à constituer un générateur de phase entre deux trains d'impulsions; et
- la figure 19 est un diagramme des temps illustrant le fonctionnement du diviseur par deux représenté sur la figure 18.

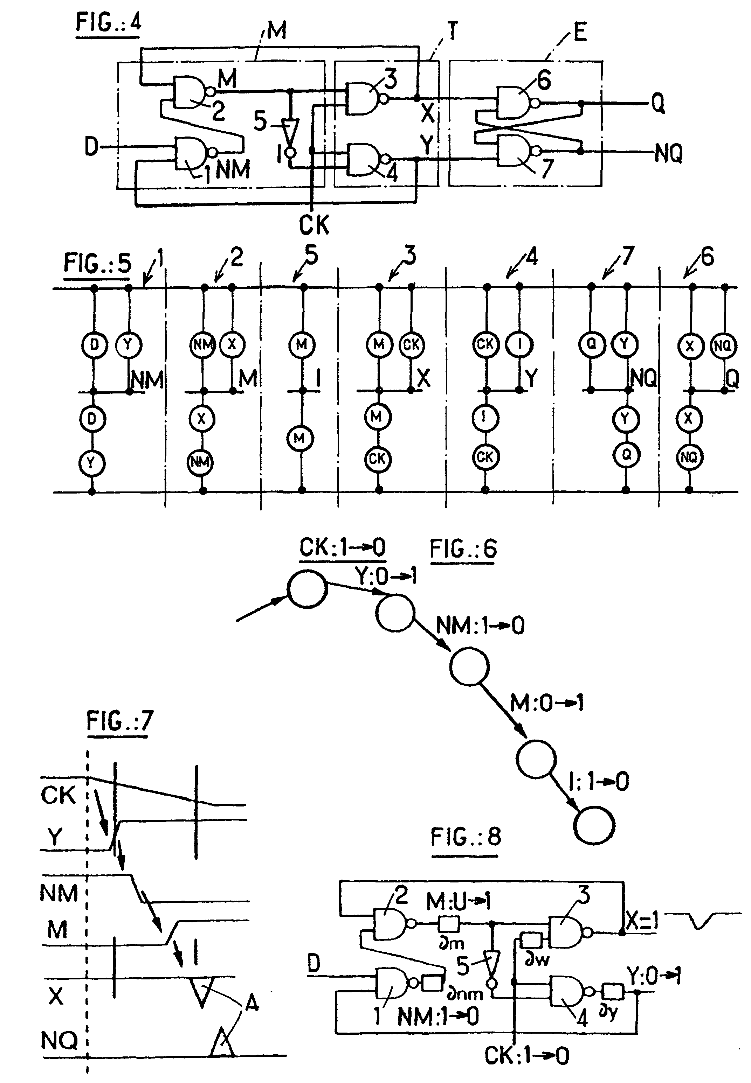

La figure 4 représente un premier mode de réalisation de la bascule maître-esclave de type D selon l'invention.

Celle-ci comprend une unité maître M et une unité esclave E entre lesquelles est reliée une unité de transfert T.

L'unité maître M comprend une première porte NON-ET 1 recevant sur l'une de ses entrées la variable D et fournissant à sa sortie une variable intermédiaire NM. Elle comprend également une seconde porte NON-ET 2 qui délivre une autre variable intermédiaire M et dont l'une des entrées est connectée à la sortie de la porte 1. Par la suite, les deux variables intermédiaires M et NM sont appelées "premières variables intermédiaires".

L'unité de transfert comporte des première et seconde portes NON-ET 3 et 4. L'une des entrées de chacune de ces portes 3 et 4 est connectée pour recevoir un signal d'horloge CK. L'autre entrée de la porte 3 est reliée la sortie de la porte 2 pour recevoir l'une M des premières variables intermédiaires. L'autre entrée de la porte 4 est reliée à la sortie d'un inverseur 5 qui délivre une variable I sur sa sortie et dont l'entrée est connectée à la sortie de la porte 2 pour recevoir la première variable intermédiaire M.

Les sorties des portes NON-ET 3 et 4 sont connectées respectivement à une autre entrée des portes 2 et 1. Elles délivrent chacune une variable intermédiaire, X et Y respectivement, que l'on appellera par la suite "secondes variables intermédiaires", ces variables étant donc rebouclées sur l'unité maître M.

L'unité esclave E comprend deux portes NON-ET 6 et 7 ayant chacune l'une de ses entrées connectée à une sortie des portes 3 et 4 pour recevoir l'une des secondes variables intermédiaires X ou Y. Les autres entrées de ces portes 6 et 7 sont connectées respectivement de façon croisées aux sorties de ces dernières en délivrant les variables de sortie Q et NQ.

Comme représenté sur la figure 5, la bascule maître-esclave de type D de la figure 4 est réalisée de préférence à l'aide de la technologie CMOS sous la forme d'une topographie en branches. On trouvera une description plus détaillée de ce type de topographie dans le brevet européen précité. Ce schéma présente 26 transistors seulement.

En considérant la figure 4, on constate que les portes 3 et 4 de l'unité de transfert T sont les seules portes du montage auxquelles est appliqué le signal d'horloge et que par ailleurs les secondes variables intermédiaires X et Y sont indépendantes l'une de l'autre, en ce qu'aucune des deux portes n'a sa sortie connectée à l'entrée de l'autre.

Lorsque, selon le diagramme de la figure 6, le signal d'horloge CK descend, la variable Y monte, suivie de la descente de la variable NM, puis de la montée de la variable M.

Le diagramme des temps de la figure 7 montre que lorsque le processus illustré à la figure 6 se déroule, il ne peut y avoir d'aléa A sur le fonctionnement de la porte 3 que si le délai cumulé des transitions des portes 1, 2 et 4 est supérieur au délai d'entrée que met le signal d'horloge CK à faire transiter la porte 3. En d'autres termes, comme illustré par le diagramme de simulation de la figure 8, un aléa ne peut se produire que si δw > δy + δnm + δm, δw, δy, δnm et δm étant respectivement les délais introduits par le signal d'horloge CK, et les portes 1, 2 et 4. Ces conditions peuvent facilement être réalisées de sorte qu'un aléa est facile à éviter.

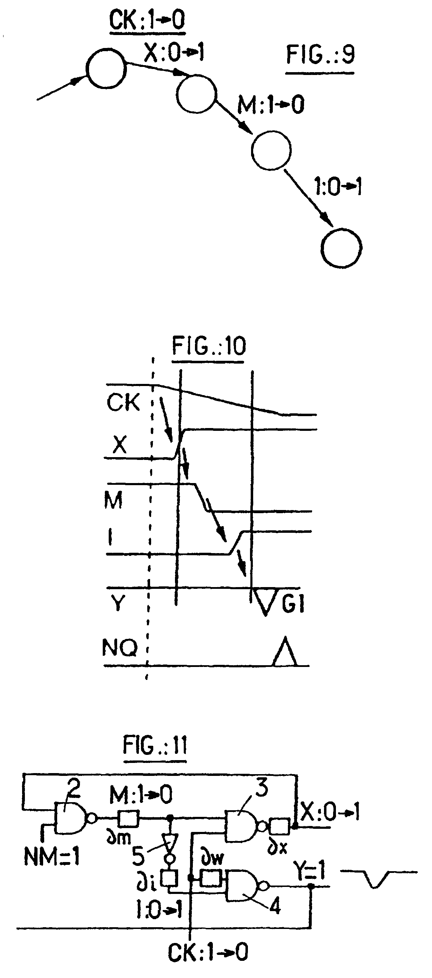

Les figures 9, 10 et 11 montrent de la même manière qu'il ne peut se produire aucun aléa A sur la porte 4, si le délai δw demeure inférieur à δx + δm +δi, δx et δi étant respectivement les délais introduits par la porte 3 et l'inverseur 5.

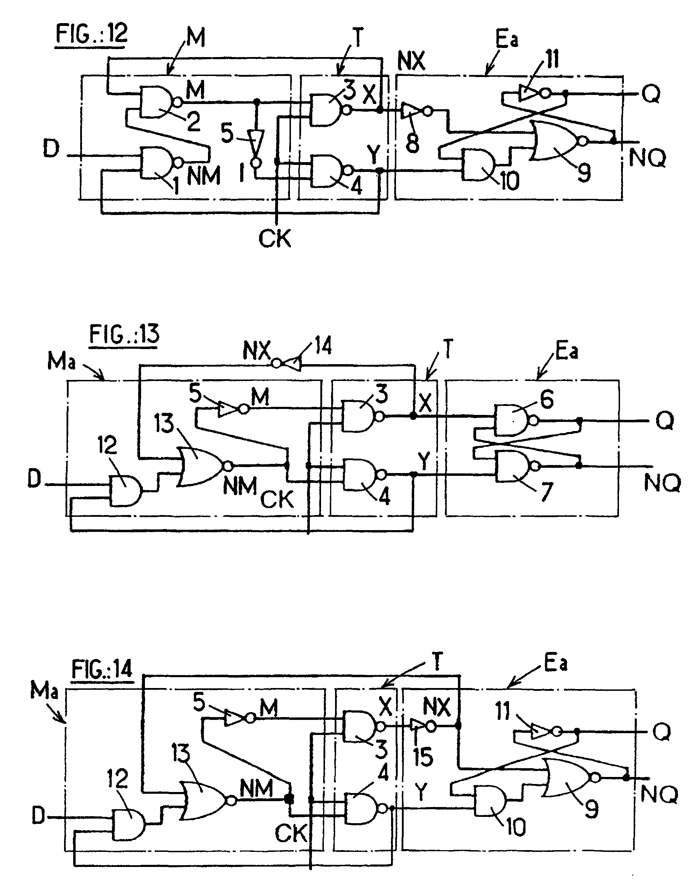

La figure 12 montre un autre mode de réalisation de l'invention qui ne diffère de celui de la figure 4 qu'en ce qu'il comporte une unité esclave Ea différente.

Cette unité esclave Ea comprend un premier inverseur 8 connecté à la sortie de l'unité de transfert T délivrant la variable X. Cet inverseur est relié à la première entrée d'une porte NON-OU 9 dont la sortie délivre la variable NQ de la bascule maître-esclave. L'autre entrée de cette porte NON-OU est connectée à la sortie d'une porte ET 10. L'une des entrées de cette dernière est raccordée à l'autre sortie de l'unité de transfert T délivrant la variable Y. L'autre entrée de la porte ET 10 est connectée à la sortie d'un inverseur 11 délivrant l'autre variable de sortie Q de la bascule D. L'entrée de l'inverseur 11 est reliée à la sortie de la porte 9.

Dans le mode de réalisation de la figure 13, les unité de transfert et esclave T et E sont identiques à celles de la figure 4. En revanche, la bascule de cette figure comprend une unité maître Ma d'une structure différente. La variable D est ici appliquée à une porte ET 12 dont l'autre entrée reçoit la seconde variable intermédiaire Y de la porte 4 de l'unité de transfert T. La sortie de la porte ET 12 est connectée à l'une des entrées d'une porte NON-OU 13 dont la sortie délivre l'une des premières variables NM à l'une des entrées de la porte 4, et à l'inverseur 5 qui fournit ici la variable M en tant que l'autre variable intermédiaire de l'unité maître Ma. La variable X est appliquée à un inverseur 14 qui fournit ainsi une variable NX à l'autre entrée de la porte NON-OU 13.

Le mode de réalisation de la bascule maître-esclave selon l'invention, représentée sur la figure 14 comporte une unité de transfert T identique à celle de la figure 4, une unité maître Ma comme celle de la figure 13 et une unité esclave Ea ayant la structure de celle de la figure 12. On notera que dans ce mode de réalisation, les inverseurs 8 et 14 peuvent être confondus dans un seul inverseur 15 délivrant la variable NX.

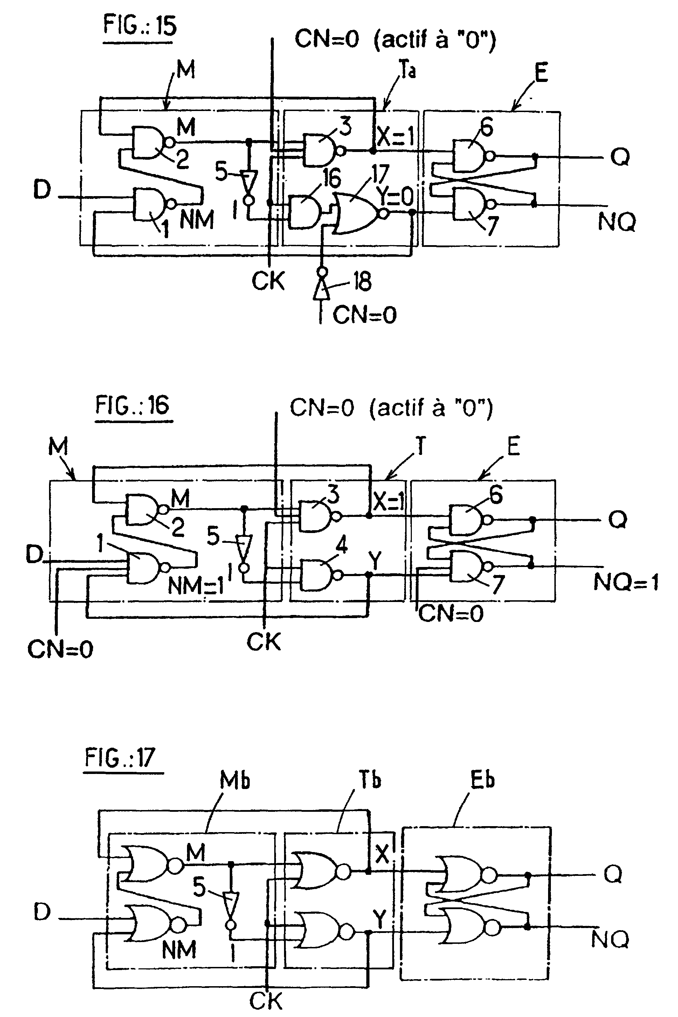

La bascule maître-esclave de la figure 15 est, dans son principe, conforme à celle de la figure 4 à ceci près qu'elle comprend une unité de transfert Ta dotant la bascule d'une fonction de "rétablissement" ou de "reset". A cet effet, cette unité de transfert Ta comprend à la place de la porte 4 délivrant la variable Y, l'ensemble d'une porte ET 16 et d'une porte NON-OU 17.

Les entrées de la porte ET 16 sont raccordées de manière à recevoir respectivement la variable d'horloge CK et la variable I, cette dernière provenant de l'inverseur 5 de l'unité maître M. Sa sortie est connectée à l'une des entrées de la porte NON-OU 17. Cette dernière reçoit sur son autre entrée une variable de reset CN via un inverseur 18. Par ailleurs, la porte 3 comprend une entrée supplémentaire recevant également la variable de reset CN. Lorsque cette dernière est active (à "0"), les portes 3 et 16, 17 sont conditionnées pour délivrer X=1 et Y=0, ce qui fera basculer à la fois le maître M et l'esclave E.

La figure 16 illustre une variante d'une bascule maître-esclave à fonction reset dans laquelle le signal de reset représenté par la variable CN agit sur les portes 1, 3 et 7 qui à cet effet comportent toutes une entrée supplémentaire. Lorsque dans ce cas le signal CN=0, les variables NM, X et NQ sont forcées à "1", tandis que les variables M, Y et Q sont forcées à "0".

D'une façon analogue, il est possible de réaliser une bascule maître-esclave D avec une fonction "set" en inversant les rôles des groupes de portes délivrant respectivement les variables NM, X et NQ et les variables M, Y et Q. Cette variante pouvant aisément être réalisée par les spécialistes en s'aidant des schémas des figures 15 et 16, elle n'est ni décrite, ni représentée plus en détail.

La figure 17 montre une variante de la bascule maître-esclave selon l'invention réalisée à l'aide d'une logique inverse, les portes NON-ET de la figure 4 ayant été remplacées par des portes NON-OU pour réaliser les trois unités maître Mb, esclave Eb et de transfert Tb. Cette bascule peut être obtenue avec le même nombre de transistors MOS (26) que celui de la bascule de la figure 4.

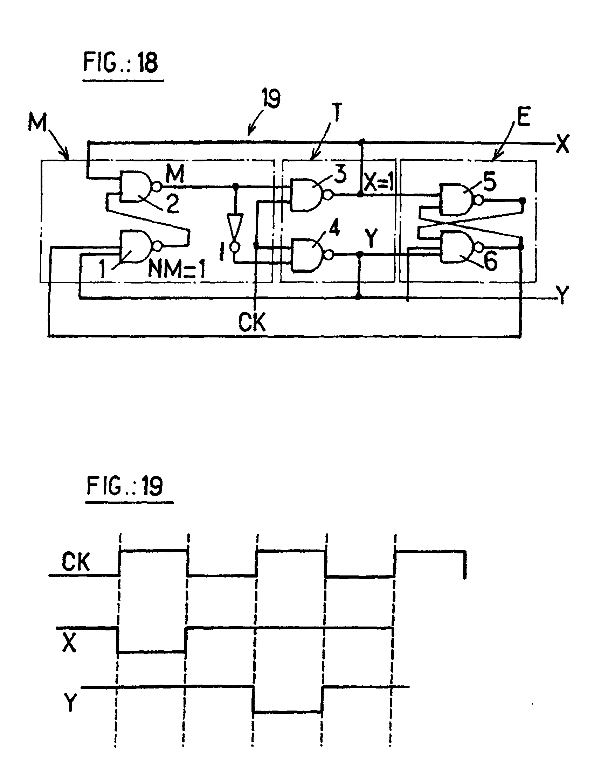

Les figures 18 et 19 illustrent une application de la bascule maître-esclave selon l'invention à un diviseur par deux 19 qui fournit sur des sorties 20 et 21 des signaux (en réalité les secondes variables intermédiaires X et Y), en opposition de phase avec une fréquence qui est la moitié de celle du signal d'horloge CK. Dans ce cas, la variable D de la figure 4 est la variable NQ délivrée par l'unité esclave E et les sorties des portes 3 et 4 délivrent respectivement les signaux de sortie de ce diviseur. Le diagramme des temps des signaux CK, X et Y sont représentés sur la figure 19.

Dans toutes les variantes décrites de la bascule maître-esclave selon l'invention, une indépendance de la pente du signal d'horloge peut être obtenue en rendant indépendantes l'une de l'autre les secondes variables intermédiaires X et Y délivrées par l'unité de transfert.

En ce qui concerne la réalisation de la bascule maître-esclave D selon l'invention, on peut noter en outre que dans presque toutes les variantes décrites la topographie en branches ne comporte dans chaque branche qu'un seul transistor de type P et deux transistors seulement de type N, cette caractéristique étant avantageuse du point de vue de la rapidité de fonctionnement de la bascule.

## Revendications

1. Bascule maître-esclave de type D réalisée en technologie de type MOS, comportant:
- une unité maître (M; Ma; Mb) recevant une variable d'entrée (D) et produisant deux premières variables intermédiaires (M, NM) fonction de cette variable d'entrée (D),
- une unité de transfert (T; Ta; Tb), connectée à ladite unité maître (M; Ma; Mb) et comportant au moins deux portes logiques (3, 4; 3, 16, 17), et une connexion d'horloge (CK) à laquelle est appliquée un signal d'horloge et qui est connectée à l'une des entrées de chacune de ces portes (3, 4; 3, 16, 17), celles-ci étant destinées à fournir respectivement deux secondes variables intermédiaires (X, Y) fonction de ladite variable d'entrée (D) et dudit signal d'horloge (CK) et étant rebouclées sur ladite unité maître (M, Ma, Mb),
- une unité esclave (E, Ea; Eb) connectée à ladite unité de transfert (T) pour former, à partir desdites secondes variables intermédiaires (X, Y), au moins une variable de sortie (Q, NQ) de la bascule,
- **caractérisée en ce que**
- une autre entrée d'une première (3) desdites portes de ladite unité de transfert (T; Ta; Tb) est connectée à ladite unité maître (M; Ma; Mb) pour recevoir directement la valeur vraie (M) de l'une desdites variables fournies par cette unité maître,
- une autre entrée de la seconde (4; 16, 17) desdites portes de ladite unité de transfert est connectée à ladite unité maître (M) pour recevoir de celle-ci le complément (I) de la même variable (M) parmi lesdites premières variables intermédiaires (M, NM), et
- lesdites secondes variables intermédiaires (X, Y) sont indépendantes l'une de l'autre.

2. Bascule maître-esclave de type D selon la revendication 1, **caractérisée en ce que** ladite unité maître (M; Ma; Mb) comprend un inverseur (5) pour fournir le complément (I) de ladite même première variable intermédiaire (M; NM).

3. Bascule maître-esclave de type D selon l'une quelconque des revendications 1 et 2, **caractérisée en ce que** lesdites unités maître, de transfert et esclave (M, T, E) comprennent chacune deux portes NON-ET.

4. Bascule maître-esclave de type D selon l'une quelconque des revendications 1 et 2, **caractérisée en ce que** lesdites unités maître, de transfert et esclave (Mb, Tb, Eb) comprennent chacune deux portes NON-OU.

5. Bascule maître-esclave de type D selon l'une quelconque des revendications 3 et 4, **caractérisée en ce que**
- une première porte (1) de ladite unité maître (M; Mb) est reliée pour recevoir sur une première de ses entrées ladite variable d'entrée (D) et sur une deuxième de ses entrées l'une (Y) des variables intermédiaires rebouclées,
- une seconde porte (2) de ladite unité maître est reliée pour recevoir sur une première de ses entrées la sortie de ladite première porte (1) et sur une seconde de ses entrées l'autre (X) desdites secondes variables rebouclées, et
- la sortie de ladite seconde porte (2) est connectée à une entrée desdites première et seconde portes (4, 5) de ladite unité de transfert (T) respectivement directement et par l'intermédiaire dudit inverseur (5).

6. Bascule maître-esclave de type D selon l'une quelconque des revendications 1 et 2, **caractérisée en ce que** ladite unité maître (Ma) comprend une porte ET (12) recevant sur ses entrées respectivement ladite variable d'entrée (D) et l'une (Y) des secondes variables intermédiaires rebouclées, et une porte NON-OU (13) connectée par l'une de ses entrées à la sortie de ladite porte ET (12) et recevant sur une autre de ses entrées l'autre seconde variable intermédiaire rebouclée (X), la sortie de ladite porte NON-OU (13) étant reliée à ladite unité de transfert (T) et audit inverseur (5).

7. Bascule maître-esclave de type D selon la revendication 1, **caractérisée en ce que** ladite unité esclave (E; Eb) comporte deux portes logiques (6,7) ayant chacune une première entrée connectée respectivement pour recevoir l'une desdites secondes variables intermédiaires (X, Y) et une seconde entrée raccordée à la sortie de l'autre porte logique de cette unité esclave (E; Eb), les sorties desdites portes logiques délivrant chacune l'une desdites variables de sortie (Q, NQ).

8. Bascule maître-esclave de type D selon la revendication 1, **caractérisée en ce que**
- ladite unité esclave (Ea) comprend une porte ET (10) dont l'une des entrées est connectée pour recevoir l'une (Y) desdites secondes variables intermédiaires, et dont la sortie est reliée à une première entrée d'une porte NON-OU (9) dont l'autre entrée est connectée pour recevoir, sous forme inversée, l'autre (X) desdites secondes variables intermédiaires,
- l'autre entrée de ladite porte ET (10) est reliée à la sortie d'un inverseur (11) fournissant une première (Q) desdites variables de sortie, et
- la sortie de ladite porte NON-OU (9) est reliée à cet inverseur (11) et fournit l'autre (NQ) desdites variables de sortie.

9. Bascule maître-esclave de type D selon l'une quelconque des revendications 1 à 8, **caractérisée en ce que** ladite unité de transfert (T) est pourvue d'une entrée supplémentaire de commande (CN) sur au moins l'une de ses portes (3, 4) pour conférer à ladite bascule une fonction de set ou de reset.

10. Application d'une bascule maître-esclave de type D selon l'une quelconque des revendications précédentes comme diviseur par deux, **caractérisée en ce que** l'une desdites variables de sortie (NQ) est rebouclée pour constituer ladite variable d'entrée (D) et **en ce que** lesdites secondes variables de sortie (X, Y) constituent des sorties en opposition de phase avec une fréquence qui est moitié de la fréquence dudit signal d'horloge.

## Patentansprüche

1. Master-Slave-Kippschaltung vom Typ D in MOS-Technik, mit:
- einer Master-Einheit (M; Ma; Mb), die eine Eingangsvariable (D) empfängt und zwei erste Zwischenvariable (M, NM) in Abhängigkeit von dieser Eingangsvariablen (D) erzeugt,
- einer Übertragungseinheit (T; Ta; Tb), die mit der Master-Einheit (M; Ma; Mb) verbunden ist und mindestens zwei Logik-Torschaltungen (3, 4; 3, 16, 17) und einen Zeitgeberanschluss (CK) aufweist, an den ein Zeitgebersignal angelegt wird und der mit einem der Eingänge jeder der Torschaltungen (3, 4; 3, 16, 17) verbunden ist, wobei diese dazu dienen, zwei zweite Zwischenvariable (X, Y) zu liefern, die eine Funktion der Eingangsvariablen (D) und des Zeitgebersignals (CK) sind und die in einer Schleife zu der Master-Einheit (M, Ma; Mb) zurückgeführt werden,
- einer Slave-Einheit (E, Ea; Eb), die mit der Übertragungseinheit (T) verbunden ist, um ausgehend von den zweiten Zwischenvariablen (X, Y) mindestens eine Ausgangsvariable (Q, NQ) der Kippschaltung zu bilden,
- **dadurch gekennzeichnet, dass**
- ein anderer Eingang einer ersten (3) der Torschaltungen der Übertragungseinheit (T; Ta; Tb) mit der Master-Einheit (M; Ma; Mb) verbunden ist, um unmittelbar den echten Wert (M) einer der von dieser Master-Einheit gelieferten Variablen zu empfangen,
- ein anderer Eingang der zweiten (4; 16, 17) der Torschaltungen der Übertragungseinheit mit der Master-Einheit (M) verbunden ist, um von dieser das Komplement (I) derselben Variablen (M) aus den ersten Zwischenvariablen (M, NM) zu empfangen, und
- die zweiten Zwischenvariablen (X, Y) voneinander unabhängig sind.

2. Master-Slave-Kippschaltung vom Typ D nach Anspruch 1, **dadurch gekennzeichnet, dass** die Master-Einheit (M; Ma; Mb) einen Inverter (5) aufweist, um das Komplement (I) der besagten gleichen ersten Zwischenvariablen (M; NM) zu liefern.

3. Master-Slave-Kippschaltung vom Typ D nach einem der Ansprüche 1 und 2, **dadurch gekennzeichnet, dass** die Master-Einheit, die Übertragungseinheit und die Slave-Einheit (M, T, E) jeweils zwei NICHT-UND-Torschaltungen aufweisen.

4. Master-Slave-Kippschaltung vom Typ D nach einem der Ansprüche 1 und 2, **dadurch gekennzeichnet, dass** die Master-Einheit, die Übertragungseinheit und die Slave-Einheit (Mb, Tb, Eb) jeweils zwei NICHT-ODER-Torschaltungen aufweisen.

5. Master-Slave-Kippschaltung vom Typ D nach einem der Ansprüche 3 und 4, **dadurch gekennzeichnet, dass**
- eine erste Torschaltung (1) der Master-Einheit (M; Mb) so angeschlossen ist, dass sie an einem ersten ihrer Eingänge die Eingangsvariable (D) und an einem zweiten ihrer Eingänge die eine (Y) der zurückgeführten Zwischenvariablen empfängt,
- eine zweite Torschaltung (2) der Master-Einheit so angeschlossen ist, dass sie, an einem ersten ihrer Eingänge den Ausgang der ersten Torschaltung (1) und an einem zweiten ihrer Eingänge die andere (X) der zweiten zurückgeführten Variablen empfängt, und
- der Ausgang der zweiten Torschaltung (2) mit einem Eingang der ersten und zweiten Torschaltungen (4, 5) der Übertragungseinheit (T) direkt bzw. über den Inverter (5) verbunden ist.

6. Master-Slave-Kippschaltung vom Typ D nach einem der Ansprüche 1 und 2, **dadurch gekennzeichnet, dass** die Master-Einheit (Ma) eine ET-Torschaltung (12), die an ihren Eingängen die Eingangsvariable (D) bzw. die eine (Y) der zweiten zurückgeführten Zwischenvariablen empfängt, und eine NICHT-ODER-Torschaltung (13) aufweist, die durch den einen ihrer Eingänge mit dem Ausgang der ET-Torschaltung (12) verbunden ist und an einem anderen ihrer Eingänge die andere zweite zurückgeführte Zwischenvariable (X) empfängt, wobei der Ausgang der NICHT-ODER-Torschaltung (13) mit der Übertragungseinheit (T) und dem Inverter (5) verbunden ist.

7. Master-Slave-Kippschaltung vom Typ D nach Anspruch 1, **dadurch gekennzeichnet, dass** die Slave-Einheit (E; Eb) zwei Logik-Torschaltungen (6, 7) aufweist, die jeweils einen ersten Eingang und einen zweiten Eingang haben, von denen der erste Eingang so angeschlossen ist, dass er die eine der zweiten Zwischenvariablen (X, Y) empfängt, und der zweite Eingang an dem Ausgang der anderen Logik-Torschaltung dieser Slave-Einheit (E; Eb) angeschlossen ist, wobei die Ausgänge der Logik-Torschaltungen jeweils die eine der Ausgangsvariablen (Q, NQ) abgeben.

8. Master-Slave-Kippschaltung vom Typ D nach Anspruch 1, **dadurch gekennzeichnet, dass**
- die Slave-Einheit (Ea) eine ET-Torschaltung (10) aufweist, von deren Eingängen der eine so angeschlossen ist, dass er die eine (Y) der zweiten Zwischenvariablen empfängt und deren Ausgang mit einem ersten Eingang einer NICHT-ODER-Torschalturig (9) verbunden ist, deren anderer Eingang so angeschlossen ist, dass er die andere (X) der zweiten Zwischenvariablen in invertierter Form empfängt,
- der andere Eingang der ET-Torschaltung (10) mit dem Ausgang eines Inverters (11) verbunden ist, der eine erste (Q) der Ausgangsvariablen liefert, und
- der Ausgang der NICHT-ODER Torschaltung (9) mit diesem Inverter (11) verbunden ist und die andere (NQ) der Ausgangsvariablen liefert

9. Master-Slave-Kippschaltung vom Typ D nach einem der Ansprüche 1 bis 8, **dadurch gekennzeichnet, dass** die Übertragungseinheit (T) mit einem zusätzlichen Steuereingang (CN) über mindestens eine ihrer Torschaltungen (3, 4) versehen ist, um der Kippschaltung eine Setz- oder Rücksetz-Funktion zu verleihen.

10. Anwendung einer Master-Slave-Schaltung vom Typ D nach einem der vorhergehenden Ansprüche als Durch-Zwei-Teiler, **dadurch gekennzeichnet, dass** die eine der Ausgangsvariablen (NQ) in einer Schleife zurückgeführt wird, um die Eingangsvariable (D) zu bilden, und dass die zweiten Ausgangsvariablen (X, Y) phasenentgegengesetzte Ausgänge mit einer Frequenz bilden, die die Hälfte der Frequenz des Zeitgebersignals ist.

## Claims

1. A MOS D-type master-slave flip-flop including:
- a master unit (M; Ma; Mb) receiving an input variable (D) and producing two first intermediate variables (M, NM) as a function of said input variable (D),
- a transfer unit (T; Ta; Tb) connected to said master unit (M; Ma; Mb) and including at least two logic gates (3, 4; 3, 16, 17) and a clock (CK) connection adapted to receive a clock signal and which is connected to one input of each of said gates (3, 4; 3, 16, 17), which are adapted to supply respectively two second intermediate variables (X, Y) as a function of said input variable (D) and said clock signal (CK) and are looped to said master unit (M, Ma, Mb), and
- a slave unit (E, Ea; Eb) connected to said transfer unit (T) to form at least one output variable (Q, NQ) of said flip-flop from said second intermediate variables (X, Y),
**characterized in that**,
- another input of a first gate (3) of said transfer unit (T; Ta; Tb) is connected to said master unit (M; Ma; Mb) to receive directly the true value (M) of one of said variables supplied by said master unit,
- another input of the second gate (4; 16, 17) of said transfer unit is connected to said master unit (M) to receive therefrom the complement (I) of the same variable (M) from said first intermediate variables (M, NM), and
- said second intermediate variables (X, Y) are independent of each other.

2. The D-type master-slave flip-flop according to claim 1 **characterized in that** said master unit (M; Ma; Mb) comprises an inverter (5) to provide the complement (I) of said same first intermediate variable (M; NM).

3. The D-type master-slave flip-flop according to claim 1 or 2 **characterized in that** said master, transfer and slave units (M, T, E) each comprise two NAND gates.

4. The D-type master-slave flip-flop according to claim 1 or 2 **characterized in that** said master, transfer and slave units (Mb, Tb, Eb) each comprise two NOR gates.

5. The D-type master-slave flip-flop according to claim 3 or 4 **characterized in that**
- a first gate (1) of said master unit (M; Mb) is connected to receive at a first input said input variable (D) and at a second input one (Y) of said looped intermediate variables,
- a second gate (2) of said master unit is connected to receive at a first input the output of said first gate (1) and at a second input the other (X) of said looped second variables, and
- the output of said second gate (2) is connected to an input of said first and second gates (4, 5) of said transfer unit (T), respectively directly and via said inverter (5).

6. The D-type master-slave flip-flop according to claim 1 or 2 **characterized in that** said master unit (Ma) comprises an AND gate (12) receiving at its inputs said input variable (D) and one (Y) of said looped second intermediate variables and a NOR gate (13) having one input connected to the output of said AND gate (12) and adapted to receive at another input the other looped intermediate second variable (X) , the output of said NOR gate (13) being connected to said transfer unit (T) and to said inverter (5).

7. The D-type master-slave flip-flop according to claim 1 **characterized in that** said slave unit (E; Eb) includes two logic gates (6, 7) each having a first input connected to receive respectively one of said second intermediate variables (X, Y) and a second input connected to the output of the other logic gate of said slave unit (E; Eb), the outputs of said logic gates each delivering one of said output variables (Q, NQ).

8. The D-type master-slave flip-flop according to claim 1 **characterized in that**
- said slave unit (Ea) comprises an AND gate (10), one input of which is connected to receive one (Y) of said second intermediate variables and whose output is connected to a first input of a NOR gate (9) whose other input is connected to receive, in inverted form, the other (X) of said second intermediate variables,
- the other input of said AND gate (10) is connected to the output of an inverter (11) supplying a first (Q) of said output variables, and
- the output of said NOR gate (9) is connected to said inverter (11) and supplies the other (NQ) of said output variables.

9. The D-type master-slave flip-flop according to any of claim 1 to 8 **characterized in that** said transfer unit (T) has an additional control input (CN) on at least one of its gates (3, 4) to confer a set or reset function on said flip-flop.

10. The use of a D-type master-slave flip-flop according to any preceding claim as a divider by 2, **characterized in that** one of said output variables (NQ) is looped to constitute said input variable (D) and said second output variables (X, Y) constitute outputs in phase opposition with a frequency which is half the frequency of said clock signal.
